# EUROPEAN PATENT SPECIFICATION

(11) **EP 3 407 689 B1**
(45) Date of publication and mention of the grant of the patent: **19.01.2022**
(21) Application number: 17206376.0
(22) Date of filing: 11.12.2017
(51) Int. Cl.: H05K 7/14

(54) **RACK MOUNTING SYSTEM**
REGALMONTAGESYSTEM
SYSTÈME DE MONTAGE SUR RACK

(30) Priority: 26.05.2017 TW 106118005
(43) Date of publication of application: 28.11.2018
(73) Proprietor: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Huang, Chien-Li, 821 Kaohsiung City (TW); Chen, Yao-Tsung, 821 Kaohsiung City (TW); Wang, Chun-Chiang, 821 Kaohsiung City (TW)
(74) Representative: Straus, Alexander

(56) References cited:
- WO-A1-01/06293
- US-A1- 2013 016 929
- US-A1- 2015 313 036
- US-B1- 9 089 215
- US-B2- 9 131 769

## Description

### Field of the Invention

The present invention is related to a rack mounting system.

### Background of the Invention

Generally, a rack has a first side and a second side defining a rack width. A rack mounting system comprises at least one pair of connecting assemblies, such as rail members, respectively mounted at two sides of the rack in order to mount a chassis to the rack.

The current rack mounting system can only to be applied to a rack and a chassis comply with the same specification. Once specifications or sizes of the rack and the chassis do not match, the chassis cannot be mounted to the rack.

With rapid development of information technology, dimensions (such as a width dimension) of a chassis are getting bigger to accommodate more electronic apparatuses or related components. US patent number US 9,131,769 B2 discloses such specification for the chassis with a greater width. However, when the specifications or sizes of the rack and chassis do not match, the solution disclosed in the aforementioned invention is to install a plurality of posts at inner regions of the rack, in order to reduce the original rack width of the rack. However, according to such design, only the chassis complied with one predetermined specification can be mounted to the width-reduced rack.

In addition, US patent publication number US 20150313036A1 discloses a cabinet for installing first servers or second servers different than the first servers in size, and the cabinet includes a frame and four adjusting assemblies respectively installed to four corners of the frame. Each adjusting assembly includes a first mounting bracket fixed to the frame and a second mounting bracket rotatably connected to the first bracket. When the second bracket is rotated to being received in the first bracket, the first servers can be installed to the first bracket. When the second bracket is rotated away from the first bracket, the second servers can be installed to the second bracket.

### Summary of the Invention

This in mind, the present invention aims at providing a rack mounting system.

This is achieved by a rack mounting system according to claims 1 and 6, and a rack system according to claim 10. The dependent claims pertain to corresponding further developments and improvements.

As will be seen more clearly from the detailed description following below, the claimed rack mounting system is applicable to a rack. The rack mounting system comprises a mounting mechanism, a first connecting assembly and a second connecting assembly. The mounting mechanism is configured to be detachably mounted to a first side of the rack, and movable relative to the first side of the rack. The first connecting assembly is configured to be detachably mounted to a second side of the rack. The second connecting assembly is connected to the mounting mechanism. The mounting mechanism comprises a base plate and at least one sliding member. The base plate is detachably mounted on the rack. The at least one sliding member is connected to the second connecting assembly and slidable relative to the base plate, so as to adjust a distance between the first connecting assembly and the second connecting assembly. The first connecting assembly and the second connecting assembly are configured to carry a first chassis with a first chassis width when the mounting mechanism is moved to a first position relative to the first side of the rack. Further, the mounting mechanism is configured to mount a second chassis with a second chassis width to the rack.

As will be seen more clearly from the detailed description following below, the claimed rack mounting system comprises a first connecting assembly, a second connecting assembly and a mounting mechanism. The first connecting assembly is configured to be connected to a first side of a chassis . The second connecting assembly is configured to be connected to a second side of the chassis. The mounting mechanism is connected to the second connecting assembly and comprises a base plate and at least one sliding member. The base plate is detachably mounted on a first rack. The at least one sliding member is connected to the second connecting assembly and slidable relative to the base plate, so as to adjust a distance between the first connecting assembly and the second connecting assembly. When the mounting mechanism is mounted to a first side of the first rack and the first connecting assembly is mounted to a second side of the first rack, the sliding member is configured to inwardly extend a first mounting length from the first side of the first rack in order to mount the chassis to the first rack. The first rack has a first rack width. When the mounting mechanism is mounted to a first side of a second rack and the first connecting assembly is mounted to a second side of the second rack, the sliding member is configured to inwardly extend a second mounting length from the first side of the second rack in order to mount the chassis to the second rack. The second rack has a second rack width different from the first rack width.

As will be seen more clearly from the detailed description following below, the claimed rack system comprises a rack, a first connecting assembly, a second connecting assembly and a mounting mechanism. The rack has a first side and a second side. The first connecting assembly is detachably mounted to the second side of the rack. The second connecting assembly is connected to the mounting mechanism. The mounting mechanism is configured to be mounted to a first side of the rack and comprises a base plate and at least one sliding member. The base plate is detachably mounted on the rack. The at least one sliding member is connected to the second connecting assembly and slidable relative to the base plate, so as to adjust a distance between the first connecting assembly and the second connecting assembly. The first connecting assembly and the second connecting assembly are configured to carry a first chassis with a first chassis width to the rack when the mounting mechanism is located at a first position relative to the first side of the rack. The mounting mechanism is configured to mount a second chassis with a second chassis width to the rack.

### Brief Description of the Drawings

In the following, the invention is further illustrated by way of example, taking reference to the accompanying drawings thereof:
FIG. 1 is a diagram showing a portion of a first chassis mounted to one side of a first rack according to an embodiment of the present invention;
FIG. 2 is a diagram showing the first chassis mounted to the first rack according to an embodiment of the present invention;
FIG. 3 is a diagram showing a portion of a second chassis mounted to one side of the first rack according to an embodiment of the present invention;
FIG. 4 is a diagram showing the second chassis mounted to 5 the first rack according to an embodiment of the present invention;
FIG. 5 is a diagram showing the first chassis being pulled out of the rack according to an embodiment of the present invention; and
FIG. 6 is a diagram showing the first chassis mounted to a second rack according to an embodiment of the present invention.

### Detailed Description

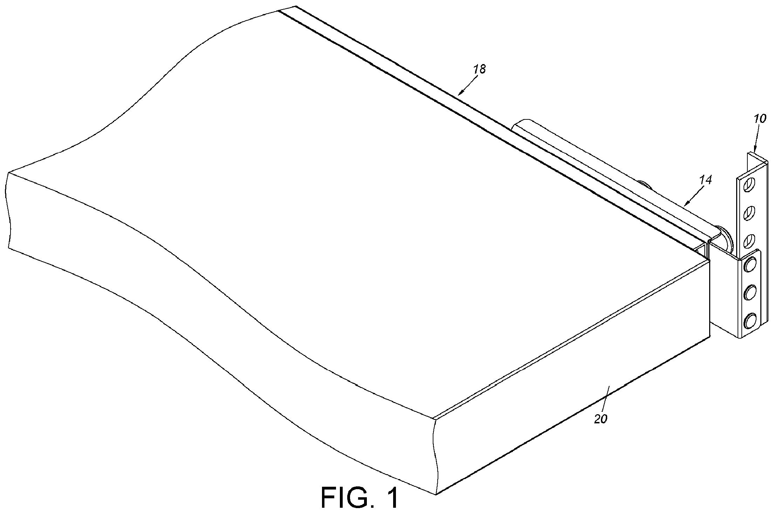

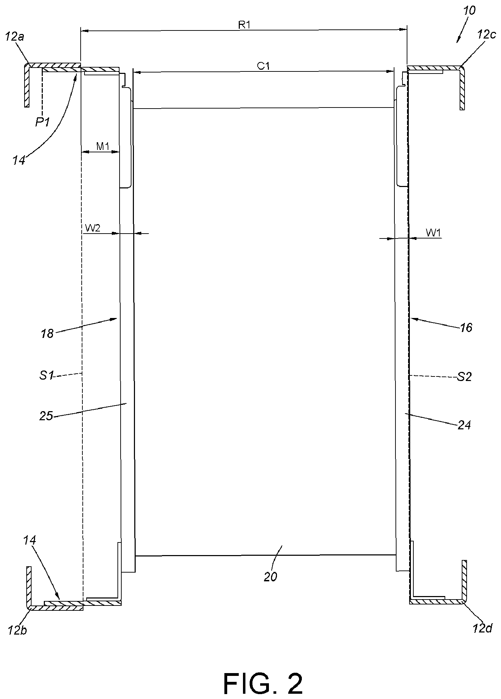

As shown in FIG. 1 and FIG. 2, a rack mounting system is applicable to a first rack 10. The first rack 10 has a plurality of posts, such as a first post 12a, a second post 12b, a third post 12C and a fourth post 12d. Wherein, the first post 12a and the second post 12b are defined as a first side SI of the first rack 10, the third post 12C and the fourth post 12d are defined as a second side S2 of the first rack 10, and a first rack width R1 is defined between the first side SI and the second side S2 of the first rack 10.

The rack mounting system comprises a mounting mechanism 14, a first connecting assembly 16 and a second connecting assembly 18. The mounting mechanism 14 is detachably mounted to one of the first side S1 and the second side S2 of the first rack 10. In the present embodiment, the mounting mechanism 14 comprises two separated components respectively detachably mounted to the first post 12a and the second post 12b of the first rack 10. That is, the mounting mechanism 14 is detachably mounted to the first side SI of the first rack 10. In another embodiment, the mounting mechanism 14 can be a single component detachably mounted to the first post 12a and the second post 12b of the first rack 10, but the present invention is not limited thereto. The first connecting assembly 16 is detachably mounted to the other one of the first side SI and the second side S2 of the first rack 10. In the present embodiment, the first connecting assembly 16 is detachably mounted to the second side S2 of the first rack 10. In addition, the second connecting assembly 18 is connected to the mounting mechanism 14. A first chassis width C1 is defined between the first connecting assembly 16 and the second connecting assembly 18. A first chassis 20 with the first chassis width Cl can be mounted to the first connecting assembly 16 and the second connecting assembly 18. For example, the first connecting assembly 16 can be connected to a first side of the first chassis 20, and the second connecting assembly 18 can be connected to a second side of the first chassis 20.

Preferably, the mounting mechanism 14 inwardly extends a first mounting length Ml relative to the first side SI of the first rack 10. The first connecting assembly 16 has a first connecting width W1. The second connecting assembly 18 has a second connecting width W2. The first mounting length Ml is greater than the first connecting width W1 and the second connecting width W2.

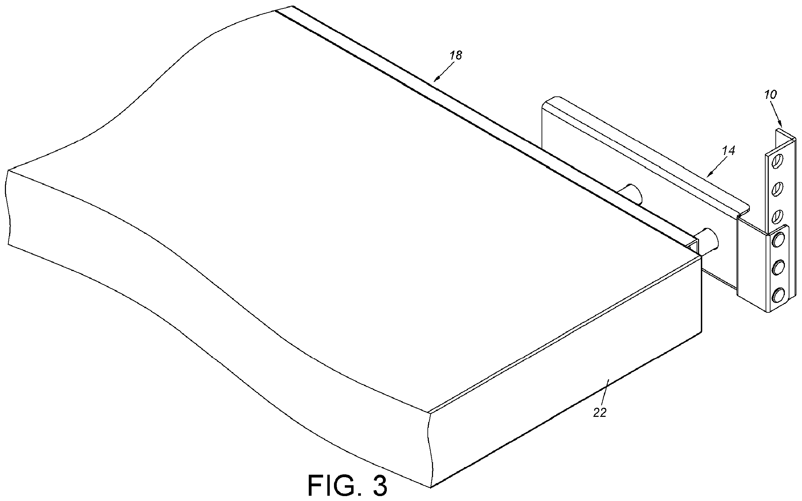

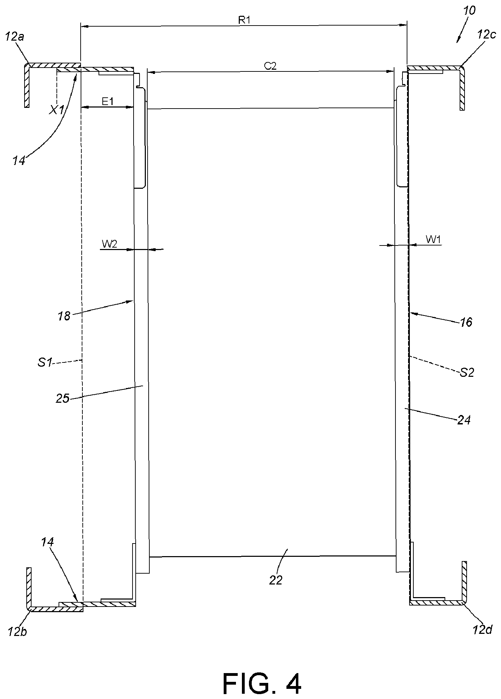

Please refer to FIG. 2 to FIG. 4. Preferably, the mounting mechanism 14 (for ease of explanation, structure and adjusting mechanism of the mounting mechanism 14 are simplified in FIG. 2 and FIG. 4) can be adjusted to move from a first position P1 to an extension position X1, such that the mounting mechanism 14 inwardly extends an extension length El from the first side S1 of the first rack 10 for forming a second chassis width C2 between the first connecting assembly 16 and the second connecting assembly 18, in order to mount a second chassis 22 with the second chassis width C2 to the fist connecting assembly 16 and the second connecting assembly 18. In another embodiment, the mounting mechanism 14 can be further adjust to mount a chassis with a different chassis width to the first rack 10.

Therefore, the mounting mechanism 14 allows the first chassis 20 with the first chassis width Cl and the second chassis 22 with the second chassis width C2 to be mounted to the first rack 10 with the first rack width R1.

Preferably, the first connecting assembly 16 comprises a first fixed rail 24, and the second connecting assembly 18 comprises a second fixed rail 25. The first fixed rail 24 and the second fixed rail 25 are configured to fixedly mount the first chassis 20 into the first rack 10. Specifications of the first fixed rail 24 and the second fixed rail 25 can be identical or different, the present invention is not limited thereto.

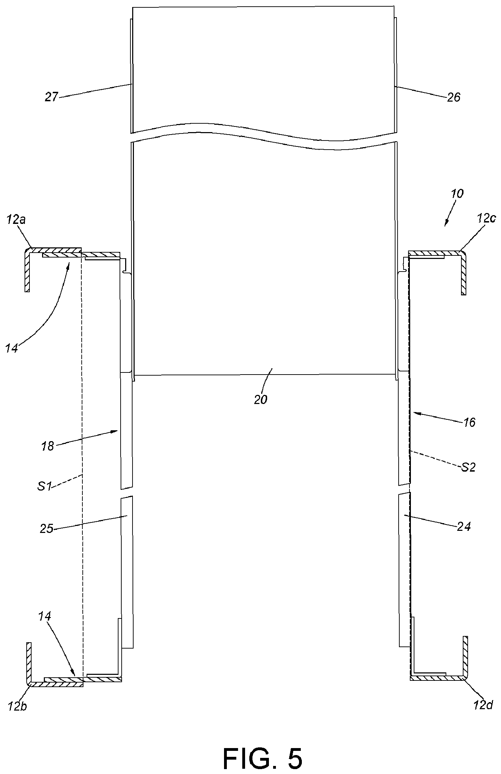

Preferably, as shown in FIG. 5, the first connecting assembly 16 comprises the first fixed rail 24 and a first movable rail 26, and the second connecting assembly 18 comprises the second fixed rail 25 and a second movable rail 27. The first movable rail 26 and the second movable rail 27 allow the first chassis 20 to be pulled out of the first rack 10. Specifications of rails of the first connecting assembly 16 and the second connecting assembly 18 can be identical or different, the present invention is not limited thereto.

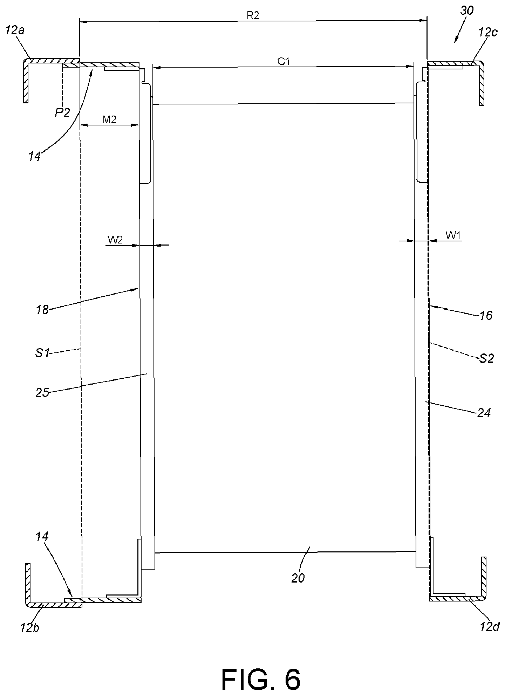

Please refer to FIG. 6. Preferably, the rack mounting system can be also applied to a second rack 30. The second rack 30 has a second rack width R2 different from the first rack width R1 of the first rack 10. The mounting mechanism 14 can be adjusted to move to a second position P2 relative to a first side S1 of the second rack 30, such that the mounting mechanism 14 inwardly extends a second mounting length M2 (different from the first mounting length Ml) from the first side S1 of the second rack 30 for forming the first chassis width Cl between the first connecting assembly 16 and the second connecting assembly 18, in order to mount the first chassis 20 with the first chassis width Cl to the first connecting assembly 16 and the second connecting assembly 18. The second mounting length M2 is greater than the first connecting width W1 and the second connecting width W2.

Therefore, the first chassis 20 with the Cl can be mounted to the first rack 10 with the first rack width R1 as shown in FIG. 2. Moreover, the first chassis 20 with the first chassis width C1 can also be mounted to the second rack 30 with the second rack width R2 as shown in FIG. 6.

According to the aforementioned illustration, the present invention is characterized in that: when the mounting mechanism 14 inwardly extends the first mounting length Ml relative to the first rack 10, the first chassis 20 with the first chassis width Cl can be mounted to the first rack 10 with the first rack width R1; and when the mounting mechanism 14 is adjusted to inwardly extend the second mounting length M2 relative to the second rack 30, the first chassis 20 with the first chassis width Cl can be mounted to the second rack 30 with the second rack width R2.

In another embodiment, the present invention is characterized in that: when the mounting mechanism 14 of the connecting assembly inwardly extends the first mounting length Ml relative to the first rack 10, the first chassis 20 with the first chassis width Cl can be mounted to the first rack 10 with the first rack width R1; and when the mounting mechanism 14 is adjusted to inwardly extends the extension length El relative to the first rack 10, the second chassis 22 with the second chassis width C2 can be mounted to the first rack 10 with the first rack width R1.

## Claims

1. A rack mounting system, applicable to a rack (10), the rack mounting system comprising:
a mounting mechanisms (14) configured to be detachably mounted to a first side of the rack (10) and movable relative to the first side of the rack (10),
a first connecting assembly (16) configured to be detachably mounted to a second side of the rack (10);
a second connecting assembly (18) connected to the mounting mechanism (14); and **characterized by**:
the mounting mechanism (14) comprising a base plate detachably mounted on the rack (10) and at least one sliding member connected to the second connecting assembly (18), the at least one sliding member being slidable relative to the base plate, so as to adjust a distance between the first connecting assembly (16) and the second connecting assembly (18);
wherein the first connecting assembly (16) and the second connecting assembly (18) are configured to carry a first chassis (20) with a first chassis width when the mounting mechanism (14) is moved to a first position relative to the first side of the rack (10);
wherein the mounting mechanism (14) is configured to mount a second chassis (22) with a second chassis width to the rack (10).

2. The rack mounting system of claim 1, **characterized in that** the first connecting assembly (16) has a first connecting width, the second connecting assembly (18) has a second connecting width, wherein the mounting mechanism (14) inwardly extends a first mounting length from the first side of the rack (10) when the mounting mechanism (14) is moved to the first position relative to the first side of the rack (10), the first mounting length is greater than the first connecting width and the second connecting width.

3. The rack mounting system of claim 1 or 2, **characterized in that** the first connecting assembly (16) and the second connecting assembly (18) are configured to carry the second chassis (22) with a second chassis width when the mounting mechanism (14) is moved to an extension position from the first position relative to the first side of the rack (10), the second chassis width is different from the first chassis width.

4. The rack mounting system of claim 1, **characterized in that** the first connecting assembly (16) comprises a first fixed rail (24), and the second connecting assembly (18) comprises a second fixed rail (25), the first fixed rail (24) and the second fixed rail (25) are configured to fixedly mount the first chassis (20) with the first chassis width into the rack (10).

5. The rack mounting system of claim 1, **characterized in that** the first connecting assembly (16) comprises a first fixed rail (24) and a first movable rail (26), and the second connecting assembly (18) comprises a second fixed rail (25) and a second movable rail (27), the first movable rail (26) and the second movable rail (27) allow the first chassis (20) with the first chassis width to be pulled out of the rack (10).

6. A rack mounting system, comprising:
a first connecting assembly (16) configured to be connected to a first side of a chassis (20);
a second connecting assembly (18) configured to be connected to a second side of the chassis (20); and
**characterized by**:
a mounting mechanism (14) connected to the second connecting assembly (18), the mounting mechanism (14) comprising a base plate detachably mounted on a first rack (10) and at least one sliding member connected to the second connecting assembly (18), the sliding member being slidable relative to the base plate, so as to adjust a distance between the first connecting assembly (16) and the second connecting assembly (18);
wherein when the mounting mechanism (14) is mounted to a first side of the first rack (10) and the first connecting assembly (16) is mounted to a second side of the first rack (10), the sliding member is configured to inwardly extend a first mounting length from the first side of the first rack (10) in order to mount the chassis (20) to the first rack (10), the first rack (10) has a first rack width;
wherein when the mounting mechanism (14) is mounted to a first side of a second rack (30) and the first connecting assembly (16) is mounted to a second side of the second rack (30), the sliding member is configured to inwardly extend a second mounting length from the first side of the second rack (30) in order to mount the chassis (20) to the second rack (30), the second rack (30) has a second rack width different from the first rack width.

7. The rack mounting system of claim 6, **characterized in that** the first connecting assembly (16) has a first connecting width, the second connecting assembly (18) has a second connecting width, the first mounting length is greater than the first connecting width and the second connecting width, the second mounting length is greater than the first connecting width and the second connecting width.

8. The rack mounting system of claim 6, **characterized in that** the first connecting assembly (16) comprises a first fixed rail (24), and the second connecting assembly (18) comprises a second fixed rail (25), the first fixed rail (24) and the second fixed rail (25) are configured to fixedly mount the chassis (20) into the first rack (10) or the second rack (30).

9. The rack mounting system of claim 6, **characterized in that** the first connecting assembly (16) comprises a first fixed rail (24) and a first movable rail (26), and the second connecting assembly (18) comprises a second fixed rail (25) and a second movable rail (27), the first movable rail (26) and the second movable rail (27) allow the chassis (20) to be pulled out of the first rack (10) or the second rack (30).

10. A rack system, comprising:
a rack (10) having a first side and a second side; and
the rack mounting system according to claim 1,

11. The rack system of claim 10, **characterized in that** the first connecting assembly (16) has a first connecting width, the second connecting assembly (18) has a second connecting width; wherein the mounting mechanism (14) inwardly extends a first mounting length from the first side of the rack (10) when the mounting mechanism (14) is located at the first position relative to the first side of the rack (10), the first mounting length is greater than the first connecting width and the second connecting width.

12. The rack system of claim 10, **characterized in that** the first connecting assembly (16) comprises a first fixed rail (24), and the second connecting assembly (18) comprises a second fixed rail (25), the first fixed rail (24) and the second fixed rail (25) are configured to fixedly mount the first chassis (20) or the second chassis (22) into the rack (10).

13. The rack system of claim 10, **characterized in that** the first connecting assembly (16) comprises a first fixed rail (24) and a first movable rail (26), and the second connecting assembly (18) comprises a second fixed rail (25) and a second movable rail (27), the first movable rail (26) and the second movable rail (27) allow the first chassis (20) to be pulled out of the rack (10).

14. The rack system of claim 10, **characterized in that** the first connecting assembly (16) comprises a first fixed rail (24) and a first movable rail (26), and the second connecting assembly (18) comprises a second fixed rail (25) and a second movable rail (27), the first movable rail (26) and the second movable rail (27) allow the second chassis (22) to be pulled out of the rack (10).

## Patentansprüche

1. Gestellbefestigungssystem, welches für ein Gestell (10) verwendbar ist, worin das Gestellbefestigungssystem umfasst:
einen Befestigungsmechanismus (14), der ausgestaltet ist, dass er entfernbar an einer ersten Seite des Gestells (10) befestigt werden kann und relativ zu der ersten Seite des Gestells (10) bewegbar ist,
ein erster Verbindungsaufbau (16), der ausgestaltet ist, dass er entfernbar an einer zweiten Seite des Gestells (10) befestigt werden kann;
ein zweiter Verbindungsaufbau (18), der mit dem Befestigungsmechanismus (14) verbunden ist; und
**dadurch gekennzeichnet, dass**
der Befestigungsmechanismus (14) eine Grundplatte, die entfernbar an dem Gestell (10) angebracht ist, und mindestens ein Gleitelement umfasst, das mit dem zweiten Verbindungsaufbau (18) verbunden ist, worin das mindestens eine Gleitelement relativ zu der Grundplatte verschiebbar ist, um einen Abstand zwischen dem ersten Verbindungsaufbau (16) und dem zweiten Verbindungsaufbau (18) anzupassen;
und dadurch dass der erste Verbindungsaufbau (16) und der zweite Verbindungsaufbau (18) ausgestaltet sind, ein erstes Chassis (20) mit einer ersten Chassisbreite zu tragen, wenn der Befestigungsmechanismus (14) in eine erste Position relativ zu der ersten Seite des Gestells (10) bewegt wird;
worin der Befestigungsmechanismus (14) ausgestaltet ist, ein zweites Chassis (22) mit einer zweiten Chassisbreite an dem Gestell (10) zu befestigen.

2. Gestellbefestigungssystem nach Anspruch 1, **dadurch gekennzeichnet, dass** der erste Verbindungsaufbau (16) eine erste Verbindungsbreite aufweist, der zweite Verbindungsaufbau (18) eine zweite Verbindungsbreite aufweist, worin sich der Befestigungsmechanismus (14) um eine erste Befestigungslänge von der ersten Seite des Gestells (10) nach innen erstreckt, wenn der Befestigungsmechanismus (14) in die erste Position relativ zu der ersten Seite des Gestells (10) bewegt wird, worin die erste Befestigungslänge größer ist als die erste Verbindungsbreite und die zweite Verbindungsbreite.

3. Gestellbefestigungssystem nach Anspruch 1 oder 2, **dadurch gekennzeichnet, dass** der erste Verbindungsaufbau (16) und der zweite Verbindungsaufbau (18) ausgestaltet sind, das zweite Chassis (22) mit einer zweiten Chassisbreite zu tragen, wenn der Befestigungsmechanismus (14) aus der ersten Position relativ zur ersten Seite des Gestells (10) in eine Ausfahrposition bewegt wird, wobei die zweite Chassisbreite von der ersten Chassisbreite verschieden ist.

4. Gestellbefestigungssystem nach Anspruch 1, **dadurch gekennzeichnet, dass** der erste Verbindungsaufbau (16) eine erste feste Schiene (24) umfasst und der zweite Verbindungsaufbau (18) eine zweite feste Schiene (25) umfasst, wobei die erste feste Schiene (24) und die zweite feste Schiene (25) ausgestaltet sind, das erste Chassis (20) mit der ersten Chassisbreite fest in dem Gestell (10) zu befestigen.

5. Gestellbefestigungssystem nach Anspruch 1, **dadurch gekennzeichnet, dass** der erste Verbindungsaufbau (16) eine erste feste Schiene (24) und eine erste bewegbare Schiene (26) umfasst, und der zweite Verbindungsaufbau (18) eine zweite feste Schiene (25) und eine zweite bewegbare Schiene (27) umfasst, wobei die erste bewegbare Schiene (26) und die zweite bewegbare Schiene (27) ein Herausziehen des ersten Chassis (20) mit der ersten Chassisbreite aus dem Gestell (10) ermöglichen.

6. Gestellbefestigungssystem, welches umfasst:
einen ersten Verbindungsaufbau (16), der ausgestaltet ist, mit einer ersten Seite eines Chassis (20) verbunden zu werden;
einen zweiten Verbindungsaufbau (18), der ausgestaltet ist, mit einer zweiten Seite des Chassis (20) verbunden zu werden; und
**gekennzeichnet durch**:
einen Befestigungsmechanismus (14), der mit dem zweiten Verbindungsaufbau (18) verbunden ist, worin der Befestigungsmechanismus (14) eine Grundplatte, die entfernbar an einem ersten Gestell (10) angebracht ist, und mindestens ein Gleitelement umfasst, das mit dem zweiten Verbindungsaufbau (18) verbunden ist, worin das Gleitelement relativ zu der Grundplatte verschiebbar ist, um einen Abstand zwischen dem ersten Verbindungsaufbau (16) und dem zweiten Verbindungsaufbau (18) anzupassen;
worin das Gleitelement ausgestaltet ist, sich von der ersten Seite des ersten Gestells (10) um eine erste Befestigungslänge nach innen zu erstrecken, wenn der Befestigungsmechanismus (14) an einer ersten Seite des ersten Gestells (10) befestigt ist und der erste Verbindungsaufbau (16) an einer zweiten Seite des ersten Gestells (10) befestigt ist, um das Chassis (20) an dem ersten Gestell (10) zu befestigen, und worin das erste Gestell (10) eine erste Gestellbreite aufweist;
worin das Gleitelement ausgestaltet ist, sich von der ersten Seite des zweiten Gestells (30) um eine zweite Befestigungslänge nach innen zu erstrecken, wenn der Befestigungsmechanismus (14) an einer ersten Seite eines zweiten Gestells (30) befestigt ist und der erste Verbindungsaufbau (16) an einer zweiten Seite des zweiten Gestells (30) befestigt ist, um das Chassis (20) an dem zweiten Gestell (30) zu befestigen, und worin das zweite Gestell (30) eine zweite Gestellbreite aufweist, die sich von der ersten Gestellbreite unterscheidet.

7. Gestellbefestigungssystem nach Anspruch 6, **dadurch gekennzeichnet, dass** der erste Verbindungsaufbau (16) eine erste Verbindungsbreite aufweist, der zweite Verbindungsaufbau (18) eine zweite Verbindungsbreite aufweist, und dadurch dass die erste Befestigungslänge größer ist als die erste Verbindungsbreite und die zweite Verbindungsbreite, und die zweite Befestigungslänge größer ist als die erste Verbindungsbreite und die zweite Verbindungsbreite.

8. Gestellbefestigungssystem nach Anspruch 6, **dadurch gekennzeichnet, dass** der erste Verbindungsaufbau (16) eine erste feste Schiene (24) und der zweite Verbindungsaufbau (18) eine zweite feste Schiene (25) umfasst, worin die erste feste Schiene (24) und die zweite feste Schiene (25) ausgestaltet sind, das Chassis (20) fest in dem ersten Gestell (10) oder dem zweiten Gestell (30) zu befestigen.

9. Gestellbefestigungssystem nach Anspruch 6, **dadurch gekennzeichnet, dass** der erste Verbindungsaufbau (16) eine erste feste Schiene (24) und eine erste bewegbare Schiene (26) umfasst, und der zweite Verbindungsaufbau (18) eine zweite feste Schiene (25) und eine zweite bewegbare Schiene (27) umfasst, worin die erste bewegbare Schiene (26) und die zweite bewegbare Schiene (27) ermöglichen, das Chassis (20) aus dem ersten Gestell (10) oder dem zweiten Gestell (30) herauszuziehen.

10. Gestellsystem, welches umfasst:
ein Gestell (10) mit einer ersten Seite und einer zweiten Seite; und
das Gestellbefestigungssystem nach Anspruch 1,

11. Gestellsystem nach Anspruch 10, **dadurch gekennzeichnet, dass** der erste Verbindungsaufbau (16) eine erste Verbindungsbreite aufweist, der zweite Verbindungsaufbau (18) eine zweite Verbindungsbreite aufweist; worin sich der Befestigungsmechanismus (14) um eine erste Befestigungslänge von der ersten Seite des Gestells (10) nach innen erstreckt, wenn sich der Befestigungsmechanismus (14) in der ersten Position relativ zu der ersten Seite des Gestells (10) befindet, worin die erste Befestigungslänge größer ist als die erste Verbindungsbreite und die zweite Verbindungsbreite.

12. Gestellsystem nach Anspruch 10, **dadurch gekennzeichnet, dass** der erste Verbindungsaufbau (16) eine erste feste Schiene (24) umfasst und der zweite Verbindungsaufbau (18) eine zweite feste Schiene (25) umfasst, worin die erste feste Schiene (24) und die zweite feste Schiene (25) ausgestaltet sind, das erste Chassis (20) oder das zweite Chassis (22) fest in dem Gestell (10) zu befestigen.

13. Gestellsystem nach Anspruch 10, **dadurch gekennzeichnet, dass** der erste Verbindungsaufbau (16) eine erste feste Schiene (24) und eine erste bewegbare Schiene (26) umfasst und der zweite Verbindungsaufbau (18) eine zweite feste Schiene (25) und eine zweite bewegbare Schiene (27) umfasst, worin die erste bewegbare Schiene (26) und die zweite bewegbare Schiene (27) ein Herausziehen des ersten Chassis (20) aus dem Gestell (10) ermöglichen.

14. Gestellsystem nach Anspruch 10, **dadurch gekennzeichnet, dass** der erste Verbindungsaufbau (16) eine erste feste Schiene (24) und eine erste bewegbare Schiene (26) umfasst, und der zweite Verbindungsaufbau (18) eine zweite feste Schiene (25) und eine zweite bewegbare Schiene (27) umfasst, worin die erste bewegbare Schiene (26) und die zweite bewegbare Schiene (27) das Herausziehen des zweiten Chassis (22) aus dem Gestell (10) ermöglichen.

## Revendications

1. Système de montage de rack, applicable à un rack (10), le système de montage de rack comprenant:
un mécanisme de montage (14) configuré pour être monté de manière amovible sur un premier côté du rack (10) et mobile par rapport au premier côté du rack (10),
un premier ensemble de connexion (16) configuré pour être monté de manière amovible sur un deuxième côté du rack (10);
un deuxième ensemble de connexion (18) relié au mécanisme de montage (14); et
**caractérisé par**:
le mécanisme de montage (14) comprend une plaque de base montée de manière amovible sur le rack (10) et au moins un élément coulissant relié au deuxième ensemble de connexion (18), le au moins un élément coulissant pouvant coulisser par rapport à la plaque de base, de manière à ajuster une distance entre le premier ensemble de connexion (16) et le deuxième ensemble de connexion (18);
dans lequel le premier ensemble de connexion (16) et le deuxième ensemble de connexion (18) sont configurés pour porter un premier châssis (20) avec une première largeur de châssis lorsque le mécanisme de montage (14) est déplacé vers une première position par rapport au premier côté du rack (10);
dans lequel le mécanisme de montage (14) est configuré pour monter un deuxième châssis (22) avec une deuxième largeur de châssis sur le rack (10).

2. Système de montage de rack selon la revendication 1, **caractérisé en ce que** le premier ensemble de connexion (16) a une première largeur de connexion, le deuxième ensemble de connexion (18) a une deuxième largeur de connexion, dans lequel le mécanisme de montage (14) s'étend vers l'intérieur d'une première longueur de montage depuis le premier côté du rack (10) lorsque le mécanisme de montage (14) est déplacé vers la première position par rapport au premier côté du rack (10), la première longueur de montage est supérieure à la première largeur de connexion et à la deuxième largeur de connexion.

3. Système de montage de rack selon la revendication 1 ou 2, **caractérisé en ce que** le premier ensemble de connexion (16) et le deuxième ensemble de connexion (18) sont configurés pour porter le deuxième châssis (22) avec une deuxième largeur de châssis lorsque le mécanisme de montage (14) est déplacé vers une position d'extension depuis la première position par rapport au premier côté du rack (10), la deuxième largeur de châssis est différente de la première largeur de châssis.

4. Système de montage de rack selon la revendication 1, **caractérisé en ce que** le premier ensemble de connexion (16) comprend un premier rail fixe (24), et le deuxième ensemble de connexion (18) comprend un deuxième rail fixe (25), le premier rail fixe (24) et le deuxième rail fixe (25) sont configurés pour monter de manière fixe le premier châssis (20) avec la première largeur de châssis dans le rack (10).

5. Système de montage de rack selon la revendication 1, **caractérisé en ce que** le premier ensemble de connexion (16) comprend un premier rail fixe (24) et un premier rail mobile (26), et le deuxième ensemble de connexion (18) comprend un deuxième rail fixe (25) et un deuxième rail mobile (27), le premier rail mobile (26) et le deuxième rail mobile (27) permettent de retirer le premier châssis (20) avec la première largeur de châssis du rack (10).

6. Système de montage de rack, comprenant:
un premier ensemble de connexion (16) configuré pour être connecté à un premier côté d'un châssis (20);
un deuxième ensemble de connexion (18) configuré pour être connecté à un deuxième côté du châssis (20); et
**caractérisé par**:
un mécanisme de montage (14) connecté au deuxième ensemble de connexion (18), le mécanisme de montage (14) comprenant une plaque de base montée de manière amovible sur un premier rack (10) et au moins un élément coulissant connecté au deuxième ensemble de connexion (18), l'élément coulissant pouvant coulisser par rapport à la plaque de base, de manière à ajuster une distance entre le premier ensemble de connexion (16) et le deuxième ensemble de connexion (18);
dans lequel, lorsque le mécanisme de montage (14) est monté sur un premier côté du première rack (10) et le premier ensemble de connexion (16) est monté sur un deuxième côté du première rack (10), l'élément coulissant est configuré pour s'étendre vers l'intérieur sur une première longueur de montage à partir du premier côté du première rack (10) afin de monter le châssis (20) sur le première rack (10), le première rack (10) ayant une première largeur de rack;
dans lequel, lorsque le mécanisme de montage (14) est monté sur un premier côté d'un deuxième rack (30) et que le premier ensemble de connexion (16) est monté sur un deuxième côté du deuxième rack (30), l'élément coulissant est configuré pour s'étendre vers l'intérieur sur une deuxième longueur de montage depuis le premier côté du deuxième rack (30) afin de monter le châssis (20) sur le deuxième rack (30), le deuxième rack (30) a une deuxième largeur de rack différente de la première largeur de rack.

7. Système de montage de rack selon la revendication 6, **caractérisé en ce que** le premier ensemble de connexion (16) a une première largeur de connexion, le deuxième ensemble de connexion (18) a une deuxième largeur de connexion, la première longueur de montage est supérieure à la première largeur de connexion et à la deuxième largeur de connexion, la deuxième longueur de montage est supérieure à la première largeur de connexion et à la deuxième largeur de connexion.

8. Système de montage de rack selon la revendication 6, **caractérisé en ce que** le premier ensemble de connexion (16) comprend un premier rail fixe (24), et le deuxième ensemble de connexion (18) comprend un deuxième rail fixe (25), le premier rail fixe (24) et le deuxième rail fixe (25) sont configurés pour monter de manière fixe le châssis (20) dans le premier rack (10) ou le deuxième rack (30).

9. Système de montage de rack selon la revendication 6, **caractérisé en ce que** le premier ensemble de connexion (16) comprend un premier rail fixe (24) et un premier rail mobile (26), et le deuxième ensemble de connexion (18) comprend un deuxième rail fixe (25) et un deuxième rail mobile (27), le premier rail mobile (26) et le deuxième rail mobile (27) permettent de retirer le châssis (20) du premier rack (10) ou du deuxième rack (30).

10. Système de rack, comprenant:
un rack (10) ayant un premier côté et un deuxième côté; et
le système de montage en rack selon la revendication 1,

11. Système de rack selon la revendication 10, **caractérisé en ce que** le premier ensemble de connexion (16) a une première largeur de connexion, le deuxième ensemble de connexion (18) a une deuxième largeur de connexion; dans lequel le mécanisme de montage (14) s'étend vers l'intérieur sur une première longueur de montage depuis le premier côté du rack (10) lorsque le mécanisme de montage (14) est situé dans la première position par rapport au premier côté du rack (10), la première longueur de montage est supérieure à la première largeur de connexion et à la deuxième largeur de connexion.

12. Système de rack selon la revendication 10, **caractérisé en ce que** le premier ensemble de connexion (16) comprend un premier rail fixe (24), et le deuxième ensemble de connexion (18) comprend un deuxième rail fixe (25), le premier rail fixe (24) et le deuxième rail fixe (25) sont configurés pour monter de manière fixe le premier châssis (20) ou le deuxième châssis (22) dans le rack (10).

13. Système de rack selon la revendication 10, **caractérisé en ce que** le premier ensemble de connexion (16) comprend un premier rail fixe (24) et un premier rail mobile (26), et le deuxième ensemble de connexion (18) comprend un deuxième rail fixe (25) et un deuxième rail mobile (27), le premier rail mobile (26) et le deuxième rail mobile (27) permettent de retirer le premier châssis (20) du rack (10).

14. Système de rack selon la revendication 10, **caractérisé en ce que** le premier ensemble de connexion (16) comprend un premier rail fixe (24) et un premier rail mobile (26), et le deuxième ensemble de connexion (18) comprend un deuxième rail fixe (25) et un deuxième rail mobile (27), le premier rail mobile (26) et le deuxième rail mobile (27) permettant de retirer le deuxième châssis (22) du rack (10).
